# EUROPEAN PATENT APPLICATION

(11) **EP 3 591 548 A1**
(43) Date of publication of application: **08.01.2020**
(21) Application number: 18182235.4
(22) Date of filing: 06.07.2018
(51) Int. Cl.: G06F 17/50

(54) **INTEGRATED CIRCUITS**

(71) Applicant: Nokia Technologies Oy, 02610 Espoo (FI)
(72) Inventor: GURNE, Thibaut, 3000 Leuven (BE); COOLS, Jan, 2235 Westmeerbeek (BE); REYNAERT, Patrick, 3001 Heverlee (BE)
(74) Representative: Nokia EPO representatives

(57) **Abstract**

The specification describes an apparatus, method and computer program relating to integrated circuits. For example, there is described apparatus, comprising means providing one or more programmable cells in an integrated circuit, the one or more programmable cells each having a fixed physical layout comprising a plurality of passive electrical components, and means for programming the one or more programmable cells by connecting a plurality of said passive electrical components in a symmetrical layout to produce a combined electrical value for output to a further part of the integrated circuit.

## Description

### Field

Embodiments herein relate to integrated circuits, for example an apparatus providing an integrated circuit having one or more programmable cells and a method for providing an integrated circuit having one or more programmable cells.

### Background

Integrated circuits (ICs) are ubiquitous in modern electronic systems. The process of designing integrated circuits may involve designing an ideal schematic using appropriate computer software and translating the schematic into a layout representing the physical representation of the integrated circuit, layer by layer. The layout corresponds to the subsequently fabricated integrated circuit. However, this may lead to physical phenomena such as parasitic effects being produced, e.g. additional parasitic resistance, capacitance and/or inductance.

### Summary

In a first aspect, there is provided an apparatus, comprising: means providing one or more programmable cells in an integrated circuit, the one or more programmable cells each having a fixed physical layout comprising a plurality of passive electrical components; and means for programming the one or more programmable cells by connecting a plurality of said passive electrical components in a symmetrical layout to produce a combined electrical value for output to a further part of the integrated circuit.

The apparatus may further comprise means providing input and output terminals to the connected passive electrical components, positioned substantially at the point of symmetry of the symmetrical layout.

The programming means may be configured to connect the said electrical components in a series and/or parallel arrangement to produce the combined electrical value.

Each of the one or more programmable cells may comprise passive electrical components of the same type.

Each of the one or more programmable cells may comprise passive electrical components of different types.

The one or more programmable cells may comprise passive electrical components selected from one or more of resistors, capacitors and/or inductors.

The one or more programmable cells may be connected to, and configured to provide a bias voltage and/or current, to the further part of the integrated circuit.

The programming means may comprise one or more internal switches for connecting the plurality of said passive electrical components in a series and/or parallel arrangement

The programming means may comprise a plurality of terminals for receiving metallisation to connecting the plurality of said passive electrical components in a series and/or parallel arrangement.

In a second aspect, there is provided an integrated circuit comprising a plurality of apparatuses of any preceding definition of the first aspect, each having an output terminal connected with a respective further part of the integrated circuit by means of respective conductors having substantially identical layouts.

In the above, the means may comprise hardware such as at least part of an integrated circuit. The means may comprise software or a combination of software and hardware. The means may comprise at least one processor; and at least one memory including computer program code, the at least one memory and computer program code configured to, with the at least one processor, cause the performance of the apparatus.

In a third aspect, there is provided a method, comprising: providing one or more programmable cells in an integrated circuit layout, the one or more programmable cells each provided having a fixed physical layout comprising a plurality of passive electrical components; and programming the one or more programmable cells by connecting a plurality of said passive electrical components in a symmetrical layout to produce a combined electrical value for output to a further part of the integrated circuit layout.

The method may further comprise means providing input and output terminals to the connected electrical components, positioned substantially at the point of symmetry of the symmetrical layout.

The programming may comprise connecting the said electrical components in a series and/or parallel arrangement to produce the combined electrical value.

The programming may comprise using one or more internal switches for connecting the plurality of said passive electrical components in a series and/or parallel arrangement

The programming may comprise applying metallisation for connecting the plurality of said passive electrical components in a series and/or parallel arrangement.

In a fourth aspect, there is provided a computer program product comprising a set of instructions which, when executed on an apparatus, is configured to cause the apparatus to carry out the method of any of: providing one or more programmable cells in an integrated circuit layout, the one or more programmable cells each provided having a fixed physical layout comprising a plurality of passive electrical components; and programming the one or more programmable cells by connecting a plurality of said passive electrical components in a symmetrical layout to produce a combined electrical value for output to a further part of the integrated circuit layout.

In a fifth aspect, there is provided an apparatus comprising at least one processor, at least one memory directly connected to the at least one processor, the at least one memory including computer program code, and the at least one processor, with the at least one memory and the computer program code being arranged to perform the method of: providing one or more programmable cells in an integrated circuit layout, the one or more programmable cells each provided having a fixed physical layout comprising a plurality of passive electrical components; and programming the one or more programmable cells by connecting a plurality of said passive electrical components in a symmetrical layout to produce a combined electrical value for output to a further part of the integrated circuit layout.

In a sixth aspect, there is provided a non-transitory computer readable medium comprising program instructions stored thereon for performing a method, comprising: providing one or more programmable cells in an integrated circuit layout, the one or more programmable cells each provided having a fixed physical layout comprising a plurality of passive electrical components; and programming the one or more programmable cells by connecting a plurality of said passive electrical components in a symmetrical layout to produce a combined electrical value for output to a further part of the integrated circuit layout.

### Drawings

Example embodiments will now be described by way of non-limiting example with reference to the accompanying drawings, in which:
FIG. 1 is a schematic view of an integrated circuit cell according to an example embodiment;
FIG. 2 is a layout view of the FIG. 1 integrated circuit cell;
FIG. 3 is a schematic view of an integrated circuit cell, when programmed, according to an example embodiment;
FIG. 4 is a layout view of the FIG. 3 integrated circuit cell;
FIG. 5 is a schematic view of a line driver circuit to which the integrated circuit cell of example embodiments may be applied;
FIG. 6 is a flow diagram showing processing operations of a method according to an example embodiment;
FIG. 7 is a flow diagram of an apparatus for performing the FIG. 6 method;
FIG. 8 shows a non-volatile media according to some embodiments; and
FIG. 9 is a schematic plan view of an integrated circuit comprising multiple integrated circuit cells according to example embodiments.

### Detailed Description

Example embodiments relate to integrated circuits, also known as ICs. Example embodiments are not limited to any particular type of integrated circuit or any particular purpose of the integrated circuit. The integrated circuit may be fabricated using any suitable semiconductor material and any suitable fabrication process.

Some example embodiments relate to the design process of integrated circuits, and therefor may relate to one or both of the computer-based design phase and also the physical process by which a part of the integrated circuits are programmed to set-up required electrical characteristics for other parts of the integrated circuits. This may comprise at least part of the fabrication process, which may be computer controlled. Some example embodiments also relate to the integrated circuit produced as a result of performing methods described herein.

Example embodiments involve providing, in an integrated circuit, a programmable cell which comprises a fixed layout of plural of electrical passive components. Each of the electrical components may have substantially the same size and have the same electrical values or may different sizes and/or different electrical values.

Embodiments may provide a fixed layout of plural passive electrical components. Each of the electrical components may have or not the same electrical value, such as to create a combination of the elements (e.g. a thermometer code or binary architecture).

In this context, a "cell" is a physically distinct module of the integrated circuit having one or more electrical outputs reflective of a programmed arrangement of two or more interconnected passive electrical components. It may be dedicated to a particular type of passive component or to a number of different types of passive components. Typically, the passive components will comprise one or more of resistors, capacitors and/or inductors.

A single integrated circuit may comprise a plurality of such programmable cells.

The cell may be programmable in the sense that, whether in the design or fabrication stages, the value of the cell output is determined by selection of series and/or parallel interconnections between the passive electrical components. A mix of series and parallel interconnections may be involved in a particular cell. Programming may be by means of setting switches internal to the integrated circuit and/or by metallisation which interconnects the passive electrical components in a required arrangement to produce a required electrical value. The term programming or programmable is also therefore intended to cover switching or switchable in some embodiments.

In some embodiments, the cell may be provided at, or close to, the outermost fabricated layer of the integrated circuit.

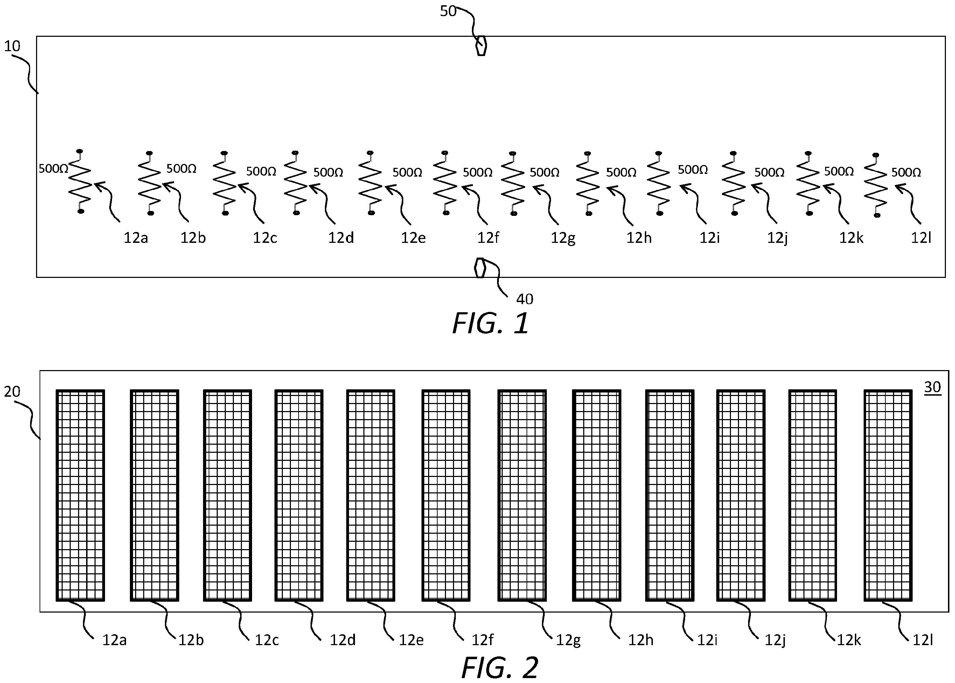

Referring to FIGS. 1 and 2, a static and programmable integrated circuit cell according to example embodiments is shown, respectively in schematic and layout views 10, 20.

It will be appreciated that, in the context of Very Large Scale Integration (VLSI) design, the schematic view is an editable, design-level version of integrated circuit components which is usually presented on a VLSI computer program. In contrast, the layout view corresponds to the actual size and locations of semiconductor elements which may comprise layers of a semiconductor crystal. The layout view of FIG. 2 corresponds to the layout produced in the semiconductor crystal when manufactured. VLSI design technology, e.g. a dedicated VLSI computer program, may be configured to convert the schematic view 10 to the layout view 20 based on internal layout rules, and the layout view may also be user-edited prior to fabrication. However, both views 10, 20 are useful for understanding embodiments herein.

The FIG. 1 and FIG. 2 views 10, 20 show a plurality of resistors 12a - 12l of a programmable resistor cell 30. The programmable resistor cell 30 may be provided on an outer layer of a fabricated integrated circuit or another layer. The FIG. 2 view 20 shows said same resistors 12a - 12l at the layout level. The programmable cell 30 when manufactured will have constant and known parasitic effects because of its fixed and known layout and physical size. The physical sizes of the individual resistors 12a - 12l are also known, and all may be of the same value, for example 500 ohms, or some other value, or the resistors may be of any number of different values and sizes.

In other embodiments, programmable capacitor cells or inductor cells may be provided having the same or similar fixed parasitic properties independent of the required electrical size as a result of the above considerations.

In consequence, regardless of how the resistors 12a - 12l of the FIG. 2 programmable cell are connected, the electrical value (in this example, one or more overall resistances due to series and/or parallel interconnections) can be set to a required value whilst the physical sizes of the resistors 12a - 12l and its routing to the rest of the circuit, and hence the parasitic effects, will not change. Any other circuit connected to terminals 40, 50 of the resistor cell 30 will have uniform parasitic effects regardless of the programmed value.

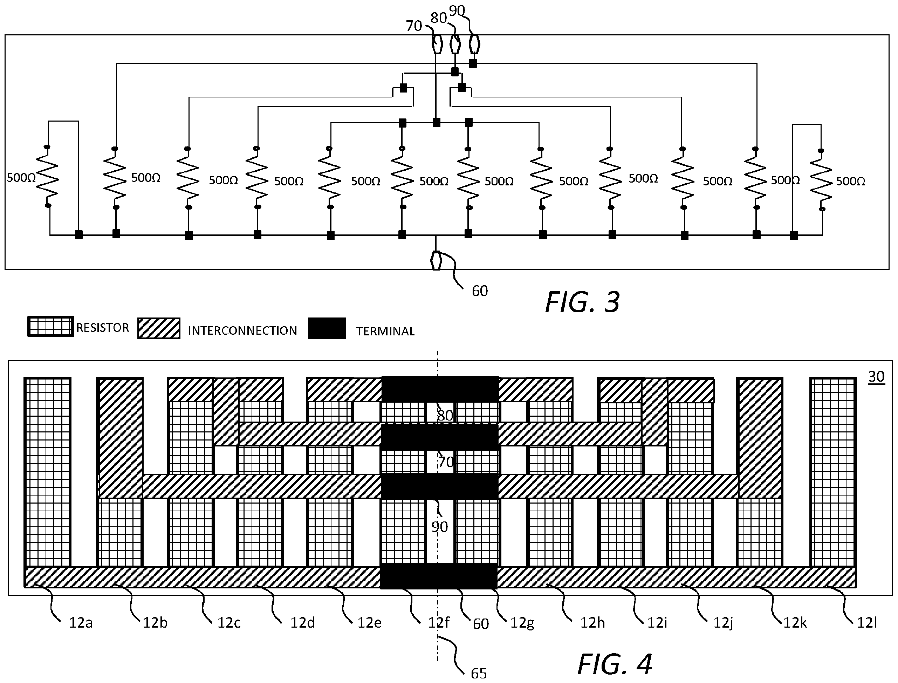

FIGS. 3 and 4 show respective schematic and layout views 10, 20 of the FIG. 1 and 2 programmable resistor cell 30, when programmed. In this example case, three different resistance values, namely 125 ohms, 62.5 ohms and 50 ohms, are set between an input terminal 60 and respective output terminals 70, 80, 90. These resistance values may, for example, be required for biasing purposes of another circuit, which may or may not form part of the integrated circuit. Given that each resistor 12a - 12l has a value of 500 ohms, these three values may be achieved by suitable programming, such as:
1) four 500 ohm resistors connected in parallel = 125 ohms;
2) eight 500 ohm resistors connected in parallel = 62.5 ohms; and
3) ten 500 ohm resistors connected in parallel = 50 ohms.

FIG. 4, in particular, shows the programmed resistor cell 30 at the layout level, with interconnections corresponding to the FIG. 3 schematic. Said interconnections may be provided by metallisation during part of the fabrication process, but said metallisation can nevertheless be configured at the VLSI design level to effect the required programming. FIG. 4 also indicates the metallisation for the respective terminal 60 and the terminals 70, 80, 90.

It will be seen from FIGS. 3 and 4 that interconnections are performed to provide a symmetrical layout. That is, a point or, as in the shown case, a line of symmetry 65 can be identified in the programmed layout such that the connected electrical components, in this case the resistors, used in the programmed resistor cell 30 are balanced either side of said point or line. This may be the case regardless of how many different resistances (or capacitance or inductance) values are provided in the cell. In the shown case, three separate resistance values are provided by three groups of interconnected resistors, and each group is balanced in symmetry either side of the point or line of symmetry 65. This layout characteristic is useful in that it provides fixed parasitic values regardless of resistor value. The parasitic values may be considered a substantially fixed offset between the programmed electrical value and the parasitic value.

In some embodiments, the respective input terminal 60 and the output terminals 70, 80, 90 may also be provided substantially on the point or line of symmetry 65. This also assists in providing fixed parasitic values regardless of resistor value.

It will be noted that the outermost resistors 12a, 12l may comprise so-called dummy resistors (or, in other embodiments, dummy capacitors or inductors). These dummy resistors 12a, 12l may be connected to the same voltage or node to provide an outer layer, with the remaining resistors 12b - 12k providing an inner layer. The resistors 12b - 12k of the inner layer may be those which are programmed in accordance with example embodiments, and the presence of the dummy resistors 12a, 12l means that the inner layer resistors 'see' the same outer structure to reduce or avoid border discontinuity effects.

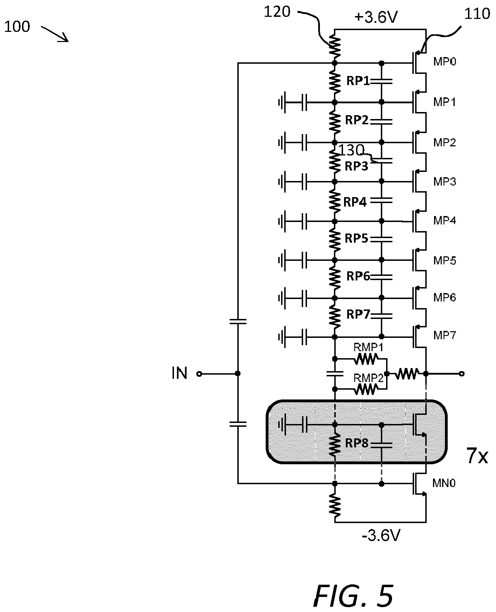

FIG. 5 is a circuit schematic which is useful for understanding an application of the above example embodiments.

FIG. 5 shows a line driver circuit 100, for example for a coaxial transmission line. The line driver circuit 100 is provided by stacking multiple transistors 110 so as to divide a maximum AC output swing equally on the different transistors. It is preferable to increase the output swing whilst avoiding an overvoltage at any transistor 110, which may damage said device. In order to maximise the output swing, the output swing should be divided equally across the different transistors 110. Asymmetry may result in a lower swing at one transistor 110 but a higher than nominal swing at another transistor. In order to achieve a uniform distribution of the output swing, a ladder structure of resistors 120 and capacitors 130 may be carefully selected to bias the transistors 110. The biasing will divide the DC supply voltage as well as the AC input voltage across respective input gates of the different transistors 110, thereby setting the voltage swing of the transistors. In practice, at the integrated circuit level, the interconnections are non-ideal and asymmetric parasitic effects may result from using resistors 120 and capacitors 130 of different values and hence different physical sizes. This means that the biasing may be asymmetric and may lead to an increase in overvoltage. However, by application of one or more resistor cells 30 and capacitor cells according to example embodiments described herein, different voltages may be set for biasing purposes. However, by application of one or more resistor cells 30 and capacitor cells according to example embodiments described herein, the parasitic effects will be uniformly on all the biasing cells made of resistors and capacitors. This leads to a symmetric ratio of the passive electrical components and hence, a symmetric distribution of the different voltages.

In summary, example embodiments may provide a static switchable or programmable cell layout, with constant parasitic effects due to a constant outer layout and physical size. The maximum value of this programmable cell may be the maximum required value, e.g. of resistance, capacitance or inductance. Otherwise, depending on how the passive electrical components are internally connected, the electrical value may be changed but not the physical size and nor the parasitic effects coupled to it. This may lead to uniform parasitic effects on all the terminals of, for example, all of the transistors 110 in the FIG. 5 example, and thus may provide uniform and symmetric biasing. Further, if interconnects have the same length, the cell will be less prone to relative variations of parasitics created by the interconnection tracks from cells across different dies.

Even in the presence of variations across fabrication dies, variations may affect all uniformly sized electrical components in the same way (i.e. they will increase or decrease by the same amount). Taking the example of FIG. 5, this means that, even if the parasitic resistance 120 and/or capacitance 130, labelled RP8 to RP1, at the gates of the transistors 110 labelled MP7 to MP0 vary, it would vary in the same way. This results in the same distribution of the biasing voltage across the different output transistors 110.

Furthermore, having a constant size resistor cell may provide a more structured, repetitive layout. This provides symmetry and thus matching of the design.

In general, embodiments herein are useful in analogue integrated circuits where matching on different nodes is important.

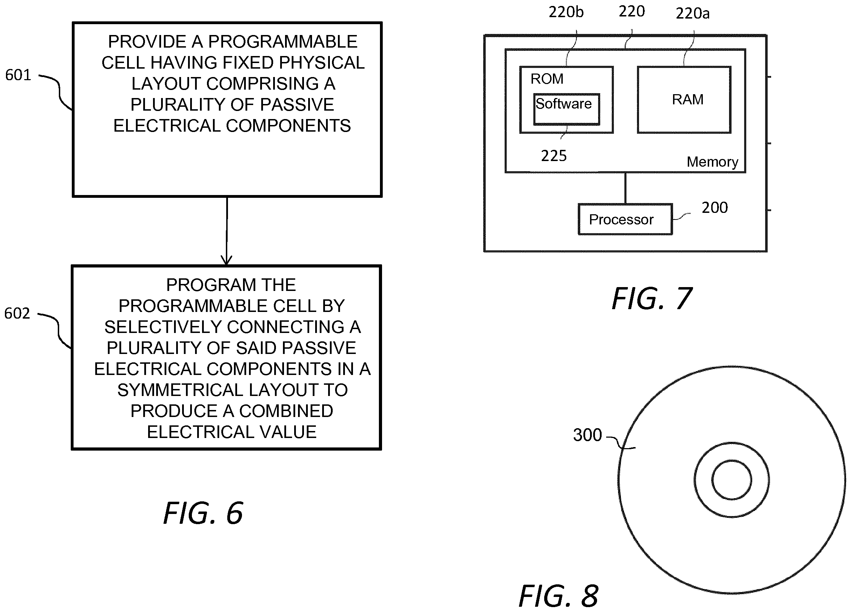

FIG. 6 is a flow diagram indicating processing operations of a method according to example embodiments. For example, the operations may be effected by one or more machines under the control of a computer program product comprising a set of instructions which, when executed on an apparatus, is configured to cause an apparatus to carry out the method. The apparatus may comprise at least one processor, at least one memory directly connected to the at least one processor, the at least one memory including computer program code, and the at least one processor, with the at least one memory and the computer program code being arranged to perform the method.

A first operation 601 may comprise providing a programmable cell having a fixed physical layout, comprising a plurality of passive electrical components A second operation 602 may comprising programming the programmable cell by selectively connecting a plurality of said passive electrical components in a series and/or parallel arrangement to produce a combined electrical value.

FIG. 7 shows an apparatus according to an embodiment, which may be configured to perform the FIG. 6 method. The apparatus comprises at least one processor 200 and at least one memory 220 directly or closely connected or coupled to the processor 200. The memory 220 may comprise at least one random access memory (RAM) 220a and at least one read-only memory (ROM) 220b. Computer program code (software) 225 may be stored in the ROM 220b. The apparatus may be connected with a user interface (UI) for instructing the apparatus and/or for outputting data such as audio/visual/haptics feedback or combination thereof. The at least one processor 200 with the at least one memory 220 and the computer program code 225 may be arranged to cause the apparatus to at least perform methods described herein.

The processor 200 may be a microprocessor, plural microprocessors, a control, or plural microcontrollers.

The memory 220 may take any suitable form.

FIG. 8 shows a non-transitory media 300 according to some embodiments. The non-transitory media 300 is a computer readable storage medium. It may be e.g. a CD, a DVD, a USB stick, a blue ray disk, etc. The non-transitory media 300 stores computer program code causing an apparatus to perform the method of FIG. 6 when executed by a processor such as processor 200 of FIG. 7.

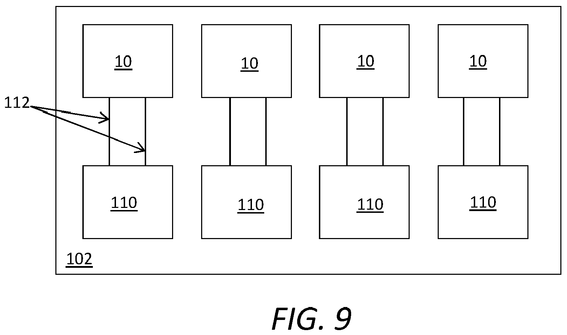

FIG. 9 is a block diagram of an example integrated circuit 102 comprising a plurality of resistor cells 10 according to example embodiments. The resistor cells 10 could of course be different types of passive electrical component cell, for example one or more of capacitor cells and/or inductor cells. Each resistor cell 10 is connected to another respective part 110 of the integrated circuit 102, for example some other circuit requiring biasing by its respective resistor cell 10. The interconnections 112 between each resistor cell 10 and its respective other part of the integrated circuit 102 comprise one or more conductors, e.g. conductive tracks, which are substantially identical in layout, e.g. in terms of path, length and width. This again assists in providing minimal variation in parasitic values presented to the other circuit parts 110.

Embodiments herein relate to reducing phenomena associated with parasitic effects in integrated circuits, for example those caused by coupling between different nodes due to physical proximity effects of metal interconnects, or by non-ideal routing tracks which increase the impedance between two nodes. The magnitude of these parasitic effects may vary depending on the layout. The design phase may take these effects into account by taking safety margins in the operation of the circuit and/or by tuning them away. However, the typical magnitude of the effects will vary drastically due to process, voltage and temperature (PVT) variations across different dies. Embodiments herein provide an advantageous apparatus, method and computer program for creating uniform parasitics for different cells.

It is to be understood that what is described above is what is presently considered the preferred embodiments. However, it should be noted that the description of the preferred embodiments is given by way of example only and that various modifications may be made without departing from the scope as defined by the appended claims.

## Claims

1. Apparatus, comprising:
means providing one or more programmable cells in an integrated circuit, the one or more programmable cells each having a fixed physical layout comprising a plurality of passive electrical components; and
means for programming the one or more programmable cells by connecting a plurality of said passive electrical components in a symmetrical layout to produce a combined electrical value for output to a further part of the integrated circuit.

2. The apparatus of claim 1, further comprising means providing input and output terminals to the connected passive electrical components, positioned substantially at the point of symmetry of the symmetrical layout.

3. The apparatus of claim 1 or claim 2, wherein the programming means is configured to connect the said electrical components in a series and/or parallel arrangement to produce the combined electrical value.

4. The apparatus of any preceding claim, wherein each of the one or more programmable cells comprises passive electrical components of the same type.

5. The apparatus of any of claims 1 to 3, wherein each of the one or more programmable cells comprises passive electrical components of different types.

6. The apparatus of any preceding claim, wherein the one or more programmable cells comprise passive electrical components selected from one or more of resistors, capacitors and/or inductors.

7. The apparatus of any preceding claim, wherein the one or more programmable cells are connected to, and configured to provide a bias voltage and/or current, to the further part of the integrated circuit.

8. The apparatus of any preceding claim, wherein the programming means comprises a plurality of terminals for receiving metallisation to connecting the plurality of said passive electrical components in a series and/or parallel arrangement.

9. An integrated circuit comprising a plurality of apparatuses of any preceding claim, each having an output terminal connected with a respective further part of the integrated circuit by means of respective conductors having substantially identical layouts.

10. A method, comprising:
providing one or more programmable cells in an integrated circuit layout, the one or more programmable cells each provided having a fixed physical layout comprising a plurality of passive electrical components; and
programming the one or more programmable cells by connecting a plurality of said passive electrical components in a symmetrical layout to produce a combined electrical value for output to a further part of the integrated circuit layout.

11. The method of claim 10, further comprising means providing input and output terminals to the connected electrical components, positioned substantially at the point of symmetry of the symmetrical layout.

12. The method of claim 10 or claim 11, wherein programming comprises connecting the said passive electrical components in a series and/or parallel arrangement to produce the combined electrical value.

13. A computer program product comprising a set of instructions which, when executed on an apparatus, is configured to cause the apparatus to carry out the method of any of:
providing one or more programmable cells in an integrated circuit layout, the one or more programmable cells each provided having a fixed physical layout comprising a plurality of passive electrical components; and
programming the one or more programmable cells by connecting a plurality of said passive electrical components in a symmetrical layout to produce a combined electrical value for output to a further part of the integrated circuit layout.

14. An apparatus comprising at least one processor, at least one memory directly connected to the at least one processor, the at least one memory including computer program code, and the at least one processor, with the at least one memory and the computer program code being arranged to perform the method of:
providing one or more programmable cells in an integrated circuit layout, the one or more programmable cells each provided having a fixed physical layout comprising a plurality of passive electrical components; and
programming the one or more programmable cells by connecting a plurality of said passive electrical components in a symmetrical layout to produce a combined electrical value for output to a further part of the integrated circuit layout.

15. A non-transitory computer readable medium comprising program instructions stored thereon for performing a method, comprising:
providing one or more programmable cells in an integrated circuit layout, the one or more programmable cells each provided having a fixed physical layout comprising a plurality of passive electrical components; and
programming the one or more programmable cells by connecting a plurality of said passive electrical components in a symmetrical layout to produce a combined electrical value for output to a further part of the integrated circuit layout.
